Europäisches Patentamt

European Patent Office

Office européen des brevets

(19)

(11) Numéro de publication: **0 066 480**

**A1**

(12) **DEMANDE DE BREVET EUROPEEN**

(21) Numéro de dépôt: **82400784.3**

(22) Date de dépôt: **29.04.82**

(51) Int. Cl.³: **H 01 L 27/14**

(30) Priorité: **12.05.81 FR 8109431**

(43) Date de publication de la demande:
**08.12.82 Bulletin 82 49**

(84) Etats contractants désignés:
**DE GB NL**

(71) Demandeur: **THOMSON-CSF**
**173, Boulevard Haussmann**
**F-75379 Paris Cedex 08(FR)**

(72) Inventeur: **Blanchard, Pierre**
**THOMSON-CSF SCPI 173, bld Haussmann**
**F-75379 Paris Cedex 08(FR)**

(72) Inventeur: **Chautemps, Jacques**
**THOMSON-CSF SCPI 173, bld Haussmann**
**F-75379 Paris Cedex 08(FR)**

(72) Inventeur: **Descure, Pierrick**
**THOMSON-CSF SCPI 173, bld Haussmann**
**F-75379 Paris Cedex 08(FR)**

(74) Mandataire: **Mayeux, Michèle et al,**
**THOMSON-CSF SCPI 173, Bld Haussmann**
**F-75379 Paris Cedex 08(FR)**

(54) Dispositif anti-éblouissement pour dispositif photosensible à transfert de charge.

(57) Ce dispositif anti-éblouissement est commun à deux canaux voisins ($C_1$ et $C_2$). Il est constitué de deux grilles ($G_1$ et $G_2$) qui sont situées sur les bords voisins des deux canaux ($C_1$ et $C_2$) et entre lesquelles est implantée une diode d'évacuation des charges (D). Ces grilles ($G_1$ et $G_2$) sont obtenues en même temps que deux autres grilles ($G_3$ et $G_4$) qui sont situées sur les bords externes des deux canaux ($C_1$ et $C_2$) et qui délimitent les bords de ces canaux. L'invention s'applique aux dispositifs photosensibles à transfert de charge, du type à transfert de trame et à transfert de ligne notamment.

d)

1

## DISPOSITIF ANTI-EBLOUISSEMENT POUR DISPOSITIF PHOTOSENSIBLE A TRANSFERT DE CHARGE.

La présente invention concerne un dispositif anti-éblouissement pour dispositif photosensible à transfert de charge.

On connaît dans l'art antérieur, notamment par l'ouvrage de C.H. SEQUIN et M.F. TOMPSETT intitulé "Charge transfer devices", pages 152 à 157, des dispositifs photosensibles surfaciques qui utilisent le transfert de charge.

Dans certains de ces dispositifs, ceux à transfert de trame et à transfert de ligne notamment, le rayonnement lumineux à analyser est reçu par des canaux de transfert des charges qui sont parallèles.

L'un des inconvénients des dispositifs de ce type est leur mauvaise résistance à l'éblouissement. Lorsqu'un point d'un des canaux se trouve trop intensément éclairé, les charges injectées en ce point se répartissent sur toute la longueur du canal et peuvent même déborder latéralement dans le substrat pour atteindre les autres canaux. Il y a donc perte d'une grande partie de l'image.

Pour supprimer cet inconvénient, il est connu d'utiliser des dispositifs anti-éblouissement qui permettent, en cas de suréclairement, l'évacuation des charges en surplus vers une diode parallèle aux canaux. De tels dispositifs sont décrits dans l'ouvrage déjà cité, pages 178 à 183.

On verra dans la description des figures 1 à 3 de la présente demande de brevet, qu'il existe des dispositifs anti-éblouissement propres à chaque canal et des dispositifs anti-éblouissement communs à deux canaux voisins :

- les premiers présentent l'inconvénient d'être trop encombrants et de réduire fortement la surface photosensible du dispositif, et donc sa sensibilité ;

- les seconds, dans les modes de réalisation connus, présentent l'inconvénient d'introduire des inégalités dans les niveaux de saturation des deux canaux voisins, et parfois aussi, de rendre inégales

2

les largeurs des deux canaux voisins.

La présente invention concerne un dispositif anti-éblouissement pour dispositif photosensible à transfert de charge, qui est commun à deux canaux voisins, et qui ne présente pas ces inconvénients.

Les niveaux de saturation des deux canaux voisins et leurs largeurs sont identiques.

Le dispositif anti-éblouissement pour dispositif photosensible à transfert de charge selon l'invention comporte des moyens assurant une diminution du potentiel de surface qui sont répartis en deux zones distinctes sur les bords voisins des deux canaux, au moins une diode polarisée en inverse étant comprise entre ces moyens ; ces moyens sont obtenus en même temps que d'autres moyens assurant une diminution de potentiel de surface qui sont répartis en deux zones distinctes sur les autres bords des deux canaux.

Les moyens asurant une diminution du potentiel de surface sont constitués soit par des implantations d'impuretés de même type que le substrat, soit par des surépaisseurs d'oxyde recouvertes à intervalles réguliers par des grilles perpendiculaires aux canaux et portées à des potentiels adaptés, ou soit encore, par des grilles portées à des potentiels adaptés.

Selon l'invention, le dispositif anti-éblouissement ne comporte plus une seule grille (ou une seule implantation d'impuretés de même type que le substrat ou une seule surépaisseur d'oxyde), mais deux, et ces deux grilles sont obtenues en même temps que les deux grilles qui limitent les canaux latéralement. Ainsi, les largeurs des canaux sont les mêmes. De plus, les niveaux de saturation des deux canaux voisins sont les mêmes car la diode d'évacuation des charges se trouve séparée de chacun des canaux par deux grilles qui sont rigoureusement de la même largeur, car elles ont été obtenues au cours de la même opération.

D'autres objets, caractéristiques et résultats de l'invention ressortiront de la description suivante, donnée à titre d'exemple non limitatif et illustrée par les figures annexées qui représentent :

- les figures 1a, 2a et 3 des schémas représentant des dispositifs anti-éblouissement selon l'art antérieur, et les figures lb et 2b des schémas illustrant le fonctionnement de ces dispositifs ;

- les figures 4a, b, c et d, 5a, b, c et d, 6a, b et c, et 7a, b, c, et d, des schémas représentant divers modes de réalisation des dispositifs anti-éblouissement selon l'invention, ainsi que divers procédés d'obtention de ces dispositifs.

Sur les différentes figures, les mêmes repères désignent les mêmes éléments, mais, pour des raisons de clarté, les cotes et proportions des divers éléments ne sont pas respectées.

La figure la, représente une vue en coupe transversale d'un dispositif anti-éblouissement selon l'art antérieur.

Il s'agit d'un dispositif anti-éblouissement propre à chaque canal du dispositif photosensible.

Sur la figure la, on constate que le substrat semi-conducteur 1, qui est généralement en silicium, est recouvert d'une couche isolante 2. Des implantations d'impuretés 4, de même type que le substrat , déterminent les bords du canal de transfert des charges. Sur la figure la, on a représenté à titre d'exemple un canal où le transfert des charges se fait en volume. Dans ce cas, une diffusion d'impuretés 3, de même type que le substrat, occupe toute la largeur du canal C. On a indiqué de façon symbolique, le sens du transfert des charges dans le canal C, qui se fait perpendiculairement au plan de la figure.

Le dispositif anti-éblouissement selon l'art antérieur est constitué par une grille G, en silicium polycristallin par exemple, qui est à la fois adjacente et parallèle au canal C, et par une diode D, polarisée en inverse, qui est située entre la grille G et l'une des diffusions d'isolement 4. Cette diode D est constituée par une zone diffusée de type opposé à celui du substrat.

Sur la figure lb, on a représenté un schéma illustrant le fonctionnement du dispositif de la figure la, et qui représente le potentiel de surface $\phi_S$ dans le substrat. Lorsque en un point quelconque du canal C il y a un suréclairement et que le niveau du potentiel de surface dans le canal dépasse le potentiel $\phi_G$ fixé par la

4

grille G, les charges en surplus sont évacuées vers la diode D.

On a vu précédemment que l'inconvénient du dispositif anti-éblouissement propre à chaque canal est d'être trop encombrant et de réduire fortement la surface photosensible du dispositif, et donc sa sensibilité.

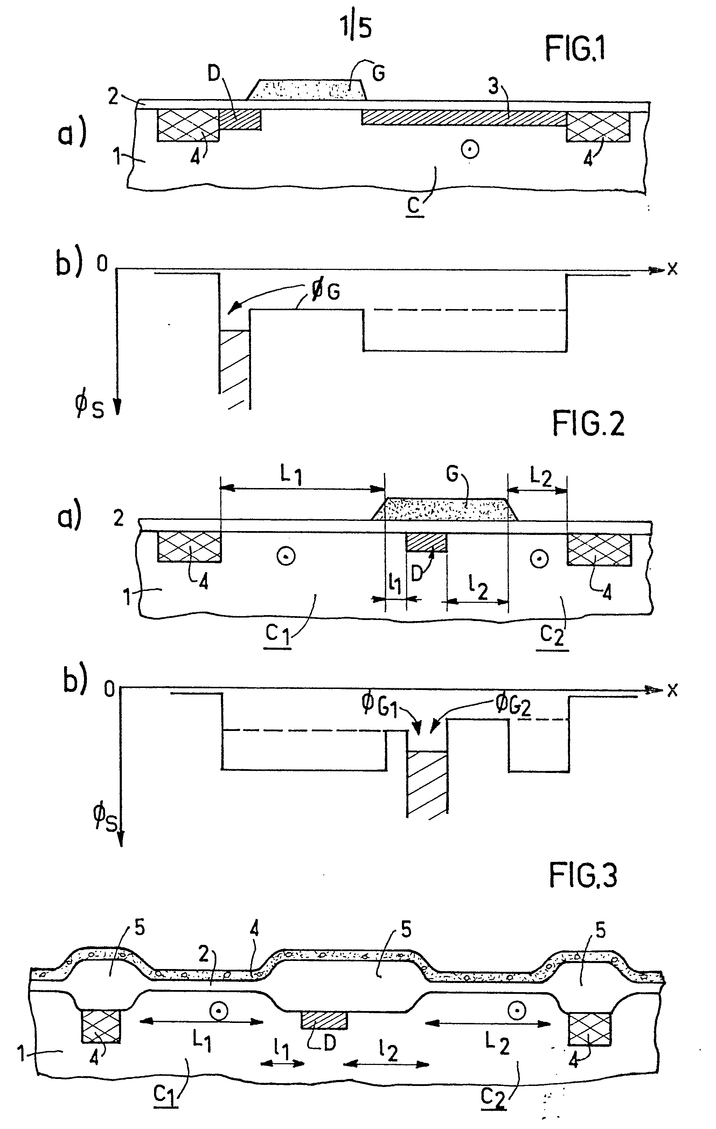

La figure 2a représente le schéma d'un mode de réalisation d'un dispositif anti-éblouissement de l'art antérieur, qui est commun à deux canaux voisins $C_1$ et $C_2$ et où le transfert des charges se fait en surface.

On réalise d'abord les diffusions d'impuretés 4, de même type que le substrat, qui déterminent les bords externes des deux canaux $C_1$ et $C_2$. Par rapport à ces diffusions 4, on implante la grille G au milieu des deux canaux $C_1$ et $C_2$. Les imprécisions d'alignement des deux masques utilisés pour réaliser les diffusions d'impuretés 4 et ensuite pour implanter la grille G sont telles que les largeurs $L_1$ et $L_2$ des canaux sont différentes. Ensuite, on réalise dans le substrat, et au milieu de la grille G, la diode D d'évacuation des charges. Mais, toujours à cause des imprécisions d'alignement des masques utilisés, les largeurs $l_1$ et $l_2$ des parties de la grille G séparant la diode D des canaux $C_1$ et $C_2$ sont différentes.

La figure 2b représente le potentiel de surface $\phi_S$ dans le substrat du dispositif de la figure 2a. Les largeurs $l_1$ et $l_2$ étant différentes, les niveaux de saturation des deux canaux $C_1$ et $C_2$ sont différents. C'est-à-dire, que c'est à partir d'un potentiel de surface $\phi_{G1}$ qu'il y aura évacuation des charges en surplus dans le canal $C_1$ vers la diode D, alors que c'est à partir d'un potentiel de surface $\phi_{G2}$, différent de $\phi_{G1}$, qu'il y aura débordement des charges en surplus dans le canal $C_2$ vers la diode D.

Le dispositif anti-éblouissement selon l'art antérieur qui est représenté sur la figure 2a présente l'inconvénient d'introduire des inégalités dans les niveaux de saturation des deux canaux voisins, et aussi, de rendre inégales les largeurs $L_1$ et $L_2$ des deux canaux voisins.

Comme la figure 2a, la figure 3 représente un dispositif anti-éblouissement selon l'art antérieur, qui est commun à deux canaux voisins. Cette fois çi, il s'agit d'un dispositif anti-éblouissement "dynamique", alors que les dispositifs anti-éblouissement des figures la et 2a sont qualifiés de "statiques". On parle de dispositif anti-éblouissement "statique" lorsque l'évacuation des charges en surplus est contrôlée par une grille différente des grilles de transfert du dispositif photosensible. Alors que dans un dispositif anti-éblouissement "dynamique", ce sont les grilles de transfert qui contrôlent l'évacuation des charges en surplus.

Pour obtenir le dispositif représenté sur la figure 3, on réalise simultanément trois surépaisseurs d'oxyde 5, les deux surépaisseurs latérales déterminent les bords externes des deux canaux $C_1$ et $C_2$ et la surépaisseur centrale fait partie du dispositif anti-éblouissement. Ces surépaisseurs d'oxyde peuvent être réalisées par dépôt d'un oxyde épais ou par oxydation à partir du substrat qui est alors consommé en profondeur. Les trois surépaisseurs d'oxyde étant réalisées au cours de la même opération, les largeurs $L_1$ et $L_2$ des canaux $C_1$ et $C_2$ sont identiques. On ne retrouve donc plus l'inconvénient de canaux de largeurs différentes qui est présenté par le dispositif de la figure 2a. Une fois les surépaisseurs d'oxyde réalisées, on implante au milieu de la surépaisseur centrale la diode d'évacuation des charges D. Mais toujours à cause des imprécisions d'alignement des masques utilisés au cours des opérations successives, les largeurs $l_1$ et $l_2$ de surépaisseurs d'oxyde qui séparent la diode D des canaux $C_1$ et $C_2$ sont différentes. On retrouve donc l'inconvénient de l'inégalité des niveaux de saturation des deux canaux voisins. Des grilles de transfert G, portées à des potentiels adaptés, recouvrent, à intervalles réguliers, toute la largeur des dispositifs photosensibles.

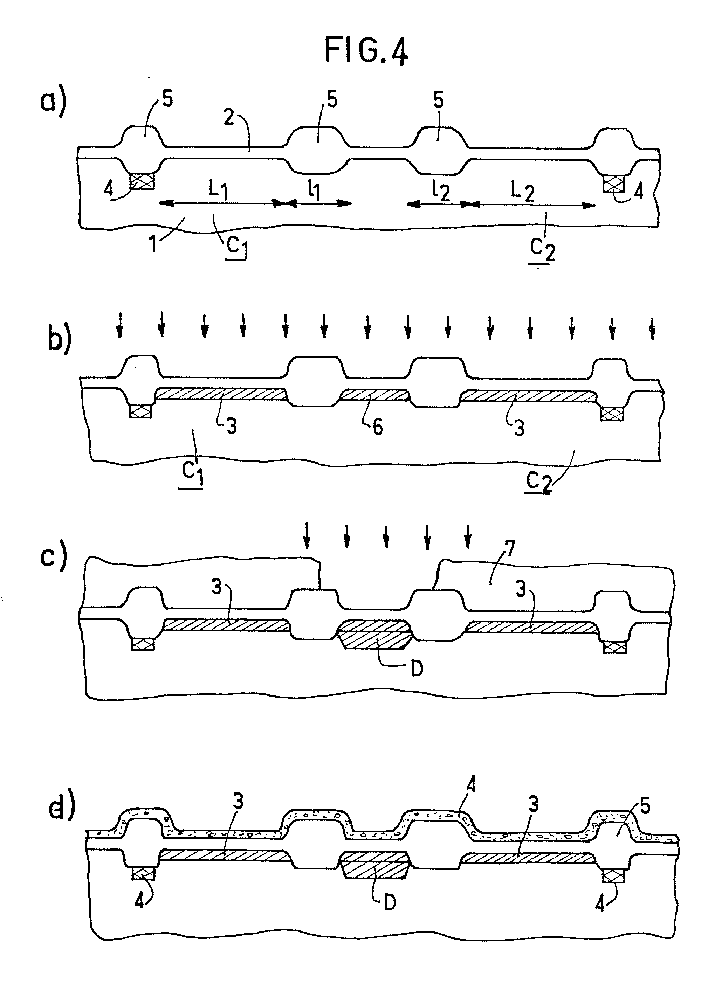

La figure 4a représente un schéma d'un mode de réalisation d'un dispositif anti-éblouissement "dynamique" selon l'invention.

Ce qui distingue le dispositif selon l'invention de celui représenté sur la figure 3 est que, cette fois çi, on réalise lors de la même opération non plus trois mais quatre surépaisseurs d'oxyde 5.

Les deux surépaisseurs d'oxyde latérales servent toujours à délimiter les bords externes des canaux $C_1$ et $C_2$, et les deux surépaisseurs d'oxyde du milieu font partie du dispositif anti-éblouissement. Ces quatre surépaisseurs d'oxyde 5 étant réalisées au cours de la même opération, on obtient des dimensions $L_1$ et $L_2$ égales entre chaque surépaisseur latérale et la surépaisseur centrale la plus proche, ainsi que des dimensions $l_1$ et $l_2$ égales pour les largeurs des deux surépaisseurs centrales.

Les dimensions $L_1$ et $L_2$ étant égales, les largeurs des deux canaux voisins auxquels s'applique le dispositif anti-éblouissement sont égales.

Sous chacune des surépaisseurs d'oxyde latérales on implante une diffusion d'impuretés 4 de même type que le substrat pour éviter une zone d'inversion sous l'oxyde.

Sur la figure 4b, on montre qu'après avoir réalisé les deux zones diffusées 4 de même type que le substrat et les quatre surépaisseurs d'oxyde 5, on utilise les surépaisseurs d'oxyde comme masque pour réaliser l'implantation d'impuretés de même type que le substrat. On obtient ainsi trois zones diffusées 3 de type opposé à celui du substrat.

Les deux zones latérales 3 permettent le transfert des charges en volume dans les canaux $C_1$ et $C_2$.

La zone diffusée 6 qui est centrale fait partie du dispositif anti-éblouissement.

La figure 4c, montre qu'après avoir déposé un masque en résine qui recouvre toute la largeur du dispositif photosensible excepté sa partie centrale et qui est donc facile à positionner, on réalise un surdopage du substrat qui permet d'obtenir la diode D d'évacuation des charges entre les deux surépaisseurs d'oxyde centrales qui servent de masque.

La figure 4d, montre le dispositif obtenu après dépôt d'une grille de transfert G.

Les distances $L_1$ et $L_2$ étant égales, les canaux $C_1$ et $C_2$ ont des largeurs identiques et les distances $l_1$ et $l_2$ étant égales, les

niveaux de saturation de ces deux canaux sont identiques.

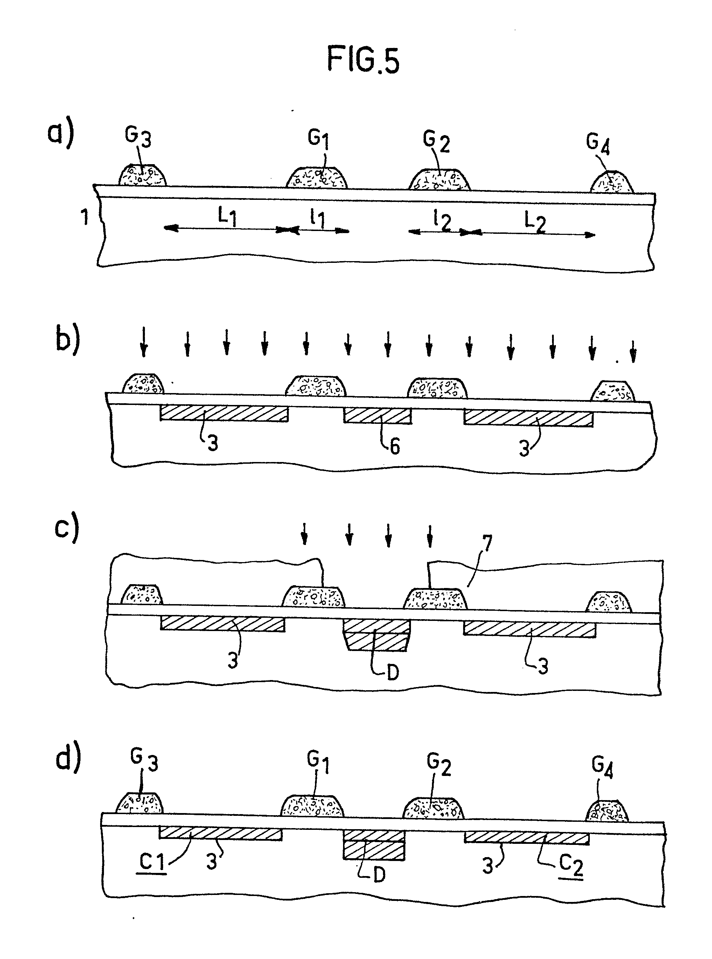

Les figures 5a, b, c, d, représentent un mode de réalisation d'un dispositif anti-éblouissement "statique" selon l'invention.

Sur la figure 5a, on montre qu'on réalise d'abord la gravure simultanée de quatre grilles $G_1$, $G_2$, $G_3$ et $G_4$, qui sont en silicium polycristallin ou en une autre couche conductrice susceptible de faire écran à une implantation ionique. La gravure des quatre grilles étant réalisée en une seule opération, les dimensions $L_1$ et $L_2$ entre les grilles centrales $G_1$ et $G_2$ et les grilles externes $G_3$ et $G_4$ sont identiques, de même, les largeurs $l_1$ et $l_2$ des grilles centrales $G_1$ et $G_2$ sont identiques.

Sur la figure 5b, on montre qu'on réalise ensuite l'implantation d'impuretés de même type que le substrat à travers le masque constitué par les grilles $G_1$ à $G_4$.       -

Trois zones diffusées de type opposé à celui du substrat sont ainsi réalisées. les deux zones latérales 3 permettent de réaliser le transfert des charges en volume dans les canaux $C_1$ et $C_2$ et la zone centrale 6 fait partie du dispositif anti-éblouissement.

Sur la figure 5c, on montre qu'après avoir déposé un masque en résine 7 qui protège le reste du dispositif et en utilisant les grilles $G_1$ et $G_2$ comme masque, on réalise un surdopage de la zone diffusée centrale 6 de façon à obtenir la diode d'évacuation des charges D. Le positionnement du masque en résine se fait sans difficulté.

La figure 5d montre le dispositif anti-éblouissement selon l'invention tel qu'il est obtenu après élimination du masque en résine 7.

Là largeur des canaux $C_1$ et $C_2$ ainsi que leur niveau de saturation sont identiques.

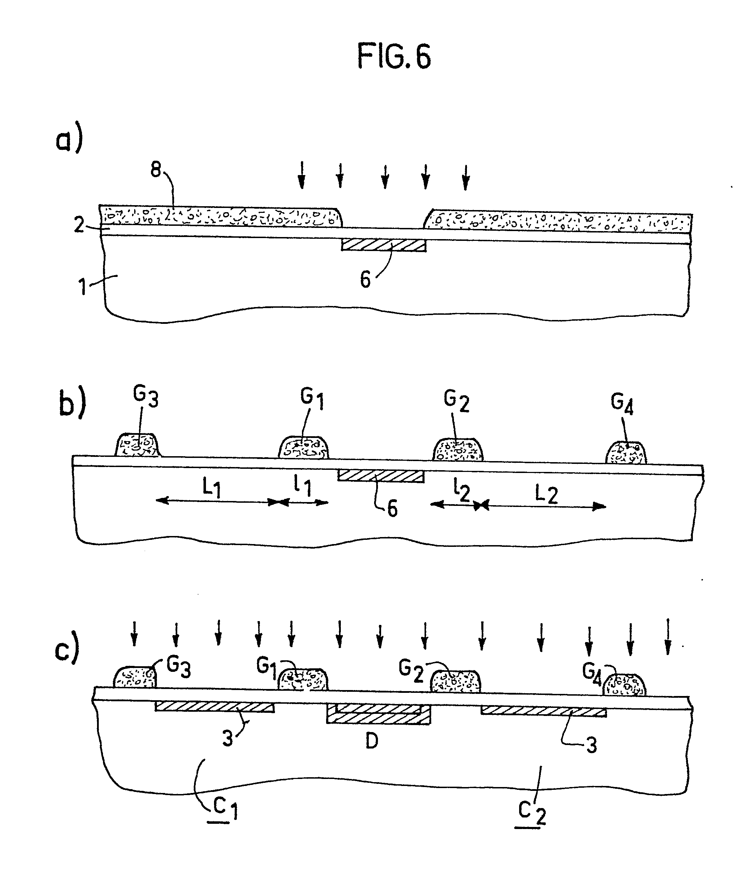

Les figures 6a, b, c, montrent comment il est possible d'obtenir un dispositif anti-éblouissement selon l'invention analogue à celui représenté sur la figure 5d, mais en procédant de façon différente.

Sur la figure 6a, on montre qu'on réalise d'abord une ouverture

8

dans la couche conductrice 8 qui recouvre la couche d'oxyde 2. Ensuite, la couche conductrice 8 servant de masque on réalise l'implantation d'impuretés de type opposé à celui du substrat de façon à obtenir une zone diffusée centrale 6.

La figure 6b, montre qu'on réalise ensuite la gravure définitive de la couche métallique 8 de façon à obtenir quatre grilles $G_1$ et $G_4$. Les distances $L_1$ et $L_2$ entre les grilles $G_1$ et $G_3$ d'une part et $G_2$ et $G_4$ d'autre part sont identiques. Les largeurs $l_1$ et $l_2$ des grilles $G_1$ et $G_2$ sont également identiques. La distance séparant les grilles $G_1$ et $G_2$ est choisie légèrement supérieure à la largeur de la zone diffusée 6.

La figure 6c, montre qu'on réalise l'implantation d'impuretés de type opposé à celui du substrat en utilisant les grilles $G_1$ à $G_4$ comme masque.

On obtient ainsi les deux zones diffusées 3, de type opposé à celui du substrat qui permettent le transfert des charges en volume dans les canaux $C_1$ et $C_2$. On réalise aussi le surdopage du substrat au niveau de la zone diffusée 6 de façon à obtenir la diode d'évacuation des charges D. La distance séparant les grilles $G_1$ et $G_2$ ayant été choisie légèrement supérieure à la largeur de la zone diffusée 6, on est assuré que la diode D d'évacuation des charges commence à l'aplomb des grilles $G_1$ et $G_2$. Ainsi est-on assuré que les niveaux de saturation des deux canaux voisins $C_1$ et $C_2$ sont identiques.

Sur les figures 4, 5, et 6 on a représenté, à titre d'exemple uniquement, divers procédés de fabrication de deux modes de réalisation du dispositif anti-éblouissement selon l'invention.

Les dispositifs anti-éblouissement selon l'invention comportent des moyens assurant une diminution de potentiel de surface qui sont répartis en deux zones distinctes sur les bords voisins des deux canaux $C_1$ et $C_2$, au moins une diode polarisée en inverse est comprise entre ces moyens. Par ailleurs, ces moyens sont obtenus en même temps que d'autres moyens assurant une diminution du potentiel de surface qui sont répartis en deux zones distinctes sur potentiel de surface qui sont répartis en deux zones distinctes sur les autres bords non voisins des deux canaux.

Au lieu d'utiliser une seule diode D polarisée en inverse qui assure l'évacuation des charges, on peut utiliser plusieurs petites diodes, réunies par un conducteur en aluminium ou en silicium polycristallin dopé, et qui sont polarisées en inverse.

Les moyens assurant une diminution du potentiel de surface peuvent être constitués par des surépaisseurs d'oxyde 5 recouverte à intervalle régulier par des grilles de transfert G portées à des potentiels adaptés, comme c'est le cas sur la figure 4d. Les moyens assurant une diminution de potentiel de surface peuvent être également constitués par des grilles, portées à des potentiels adaptés comme c'est le cas sur les figures 5d et 6c.

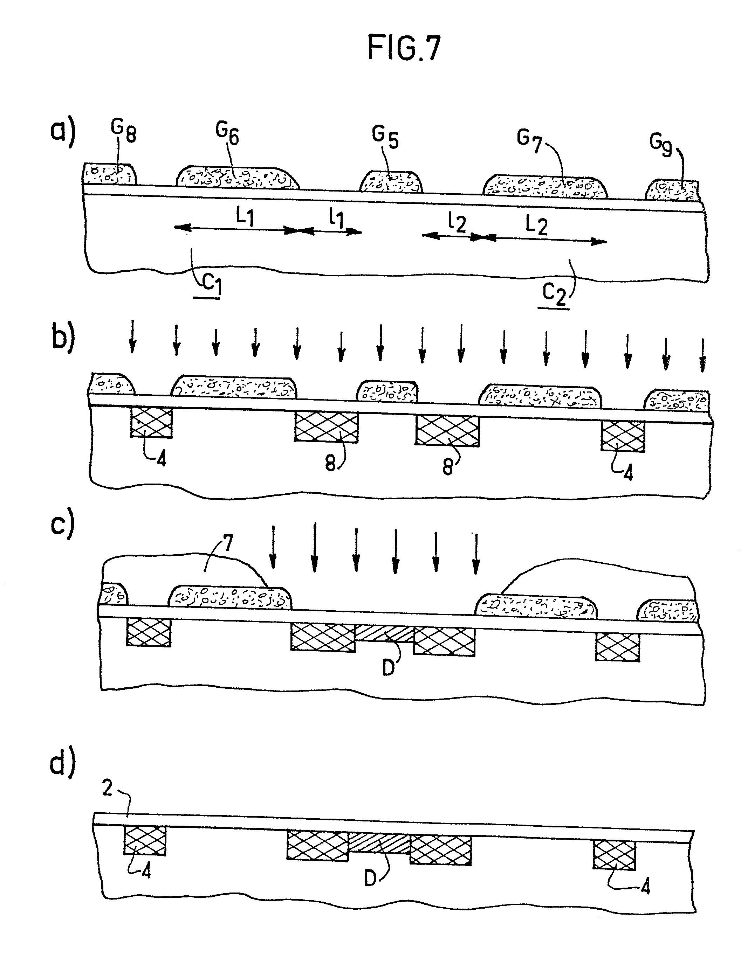

Les moyens assurant une diminution du potentiel de surface peuvent être également constitués par des implantation d'impuretés de même type que le substrat, comme on va le voir dans la description de la figure 7.

Sur la figure 7a, on montre qu'on réalise d'abord la gravure de cinq grilles de gauche à droite, $G_8$, $G_6$, $G_5$, $G_7$ et $G_9$. Les largeurs $L_1$ et $L_2$ des grilles $G_6$ et $G_7$ sont identiques. Les distances $l_1$ et $l_2$ entre les grilles $G_6$ et $G_5$ et entre les grilles $G_5$ et $G_7$ sont identiques.

Sur la figure 7b, on montre qu'on réalise l'implantation d'impuretés du même type que le substrat en utilisant les grilles comme masque. On obtient ainsi quatre zones diffusées de même type que le substrat. Les deux zones latérales 4 délimitent les bords externes des canaux $C_1$ et $C_2$, les deux zones centrales 8 font partie du dispositif anti-éblouissement.

Sur la figure 7c on montre qu'on réalise l'implantation d'impuretés de type opposé à celui du substrat dans la partie centrale du dispositif, après avoir éliminé la grille centrale $G_5$ et après avoir déposé un masque en résine 7 qui arrive jusqu'aux grilles $G_6$ et $G_7$ qui servent également de masque. Le positionnement de ce masque en résine est peu délicat.

On obtient ainsi la diode d'évacuation des charges D.

10

Sur la figure 7d, on montre le dispositif anti-éblouissement dynamique selon l'invention qui est obtenu après élimination des grilles $G_8$, $G_6$, $G_7$ et $G_9$. Comme pour tous les dispositifs anti-éblouissement selon l'invention, les largeurs des canaux $G_1$ et $G_2$ sont identiques et les niveaux de saturation des canaux sont également identiques.

11

# REVENDICATIONS

1. Dispositif anti-éblouissement pour dispositif photosensible à transfert de charge, comportant des canaux de transfert des charges parallèles, ce dispositif anti-éblouissement étant commun à deux canaux ayant des bords voisins ($C_1$ et $C_2$), caractérisé en ce qu'il comporte des moyens assurant une diminution du potentiel de surface qui sont répartis en deux zones distinctes sur les bords voisins de ces deux canaux,au moins une diode (D) polarisée en inverse étant comprise entre ces moyens, ces moyens étant obtenus en même temps que d'autres moyens assurant une diminution du potentiel de surface qui sont répartis en deux zones distinctes sur les bords non voisins des deux canaux.

2. Dispositif selon la revendication 1, caractérisé en ce qu'il comporte plusieurs diodes polarisées en inverse et réunis par un conducteur qui sont comprises entre les moyens assurant une diminution du potentiel de surface.

3. Dispositif selon l'une des revendications 1 ou 2, caractérisé en ce que les moyens assurant une diminution du potentiel de surface sont constitués par des implantations d'impuretés (8) de même type que le substrat.

4. Dispositif selon l'une des revendications 1 ou 2, caractérisé en ce que les moyens assurant une diminution de potentiel de surface sont constitués par des surépaisseurs d'oxyde (5) recouvertes à intervalles réguliers par des grilles (G) perpendiculaires aux canaux et portées à des potentiels adaptés.

5. Dispositif selon l'une des revendications 1 ou 2, caractérisé en ce que les moyens assurant une diminution du potentiel de surface sont constitués par des grilles ($G_1$ et $G_2$) portées à des potentiels adaptées.

FIG.1

a)

b)

FIG.2

a)

b)

FIG.3

# FIG.4

a)

b)

c)

d)

# FIG.5

a)

$G_3$ $G_1$ $G_2$ $G_4$

1 $L_1$ $l_1$ $l_2$ $L_2$

b)

3 6 3

c)

7

3 D 3

d)

$G_3$ $G_1$ $G_2$ $G_4$

$C_1$ 3 D 3 $C_2$

FIG.6

a)

8

2

1

6

b)

$G_3$    $G_1$    $G_2$    $G_4$

$L_1$    $l_1$    $l_2$    $L2$

6

c)

$G_3$    $G_1$    $G_2$    $G_4$

3    D    3

$\underline{C_1}$    $\underline{C_2}$

# FIG.7

a)

$G_8$    $G_6$    $G_5$    $G_7$    $G_9$

$L_1$    $l_1$    $l_2$    $L_2$

$C_1$    $C_2$

b)

4    8    8    4

c)

7

D

d)

2

4    D    4

# 0066480

RAPPORT DE RECHERCHE EUROPEENNE

Office européen des brevets

Numero de la demande

EP 82 40 0784

## DOCUMENTS CONSIDERES COMME PERTINENTS

| Categorie | Citation du document avec indication, en cas de besoin, des parties pertinentes | Revendication concernee | CLASSEMENT DE LA DEMANDE (Int Cl.³) |
|---|---|---|---|
| X,Y | US-A-4 173 064 (S.A. FARNOW) * figures 1-5; colonne 3, ligne 27 - colonne 5, ligne 21 * | 1,5 | H 01 L 27/14 |
| X,Y | DE-A-2 808 620 (SIEMENS AG.) * figures 1-3; page 7, ligne 14, page 13 * | 1-4 | |
| Y | RCA REVIEW, vol.35, no.1, mars 1974, Princeton (US) W.F. KOSONOCKY et al.: "Control of blooming in charge-coupled imagers", pages 3-24 * pages 6-13; "2-methods of blooming control" * | 1-5 | |
| Y | FR-A-2 241 879 (N.V. PHILIPS GLOEILAMPENFABRIEKEN) * figures 1-16; pages 12-32 * | 1-3,5 | |
| Y | EP-A-0 007 384 (SIEMENS AG.) * figures 1-5; page 8, ligne 12 - page 14 * | 1-4 | |

DOMAINES TECHNIQUES RECHERCHES (Int Cl.³)

H 01 L

Le present rapport de recherche a ete etabli pour toutes les revendications

| Lieu de la recherche | Date d'achevement de la recherche | Examinateur |
|---|---|---|
| LA HAYE | 21-07-1982 | CARDON A. |

CATEGORIE DES DOCUMENTS CITES

X particulierement pertinent a lui seul
Y particulierement pertinent en combinaison avec un autre document de la meme categorie
A arriere-plan technologique
O divulgation non-ecrite
P document intercalaire

T theorie ou principe a la base de l'invention
E document de brevet anterieur, mais publie a la date de depot ou apres cette date
D cite dans la demande
L cite pour d'autres raisons

& membre de la meme famille, document correspondant